# EUROPÄISCHE PATENTSCHRIFT

(11) **EP 0 815 283 B1**
(45) Veröffentlichungstag und Bekanntmachung des Hinweises auf die Patenterteilung: **19.06.2002**
(21) Anmeldenummer: 96905651.4
(22) Anmeldetag: 13.03.1996
(51) Int. Cl.: C23C 16/50, C23C 14/22, C23C 16/44, C23C 14/50, B05D 7/24

(54) **ABSCHEIDEN VON DIFFUSIONSSPERRSCHICHTEN IN EINER NIEDERDRUCKPLASMAKAMMER**
DEPOSITION OF DIFFUSION BLOCKING LAYERS WITHIN A LOW PRESSURE PLASMA CHAMBER
DEPOT DE COUCHES ATRRETANT LA DIFFUSION DANS UN CHAMBRE A PLASMA A BAS PRESSION

(30) Priorität: 14.03.1995 CH 72595
(43) Veröffentlichungstag der Anmeldung: 07.01.1998
(73) Patentinhaber: Eidgenössische Materialprüfungs- und Forschungsanstalt EMPA, 9014 St. Gallen (CH)
(72) Erfinder: MOSER, Eva Maria, 8600 Dübendorf (CH); MÜLLER, Claus, 2072 St. Blaise (CH)
(74) Vertreter: Patentanwälte Breiter + Wiedmer AG
(86) Internationale Anmeldenummer: CH9600094
(87) Internationale Veröffentlichungsnummer: WO9628587

(56) Entgegenhaltungen:
- EP-A- 0 158 133
- EP-A- 0 619 380
- DE-A- 3 521 318
- DE-A- 4 316 349
- PATENT ABSTRACTS OF JAPAN vol. 015, no. 474 (C-0890), 3.Dezember 1991 & JP,A,03 202467 (DENKI KOGYO CO LTD), 4.September 1991,
- PATENT ABSTRACTS OF JAPAN vol. 014, no. 377 (C-0748), 15.August 1990 & JP,A,02 138464 (MEIDENSHA CORP), 28.Mai 1990,
- DATABASE WPI Section Ch, Week 9318 Derwent Publications Ltd., London, GB; Class A23, AN 93-146660 XP002006300 & JP,A,05 081 659 (TDK CORP) , 2.April 1993
- PATENT ABSTRACTS OF JAPAN vol. 018, no. 401 (C-1231), 27.Juli 1994 & JP,A,06 116724 (NISSIN ELECTRIC CO LTD), 26.April 1994,
- PATENT ABSTRACTS OF JAPAN vol. 008, no. 103 (E-244), 15.Mai 1984 & JP,A,59 018685 (MATSUSHITA DENKI SANGYO KK), 31.Januar 1984,

## Beschreibung

Die vorliegende Erfindung betrifft ein Verfahren zum Abscheiden von Diffusionssperrschichten nach dem Oberbegriff der Patentansprüche 1 bis 3, eine Anwendung der Verfahren und eine Niederdruckplasmakammer zur Durchführung der Verfahren.

Niederdruckentladungen spielen bei der Anwendung der Plasmatechnik zur Applikation von funktionalen Schichten, wie insbesondere bei der Plasmapolymerisation, eine zunehmend bedeutende Rolle.

Einer der Vorteile von Niederdruckentladungen besteht in der Möglichkeit einer sogenannten "kalten" Prozessführung, was insbesondere bei der Plasmapolymerisation von grundlegender Bedeutung ist. Die Entscheidung der Prozesswahl, ob beispielsweise eine Gleichstromentladung, eine Hochfrequenzentladung, eine Mikrowellenentladung, etc. verwendet werden soll, wird von den Prozessanforderungen, wie Homogenität und Reinheit der Entladung,
Schichteigenschaften als Funktion der Abscheiderate, geforderter Hochskalierungsgrad und von der Investitionsbereitschaft bestimmt. Fundierte Untersuchungen, welche zur optimalen Wahl bei den verschiedenen Entladungsarten führen, fehlen jedoch hinsichtlich der funktionalen Beschichtungen, wie insbesondere der Plasmapolymerisation bis anhin.

Die verschiedenen Niederdruckplasmatechniken werden beispielsweise im Referat "Niederdruckplasmatechnik: von Gleichstrom über Puls bis Mikrowelle" des Autoren G.Böhm et al., Referat zur Plasmatec '93 in Duisburg vergleichend beschrieben. Insbesondere bei den seit geraumer Zeit amorphen diamantartigen Kohlenstoffbeschichtungen sind zahlreiche, unter anderem grundlegende Arbeiten mit Hochfrequenzentladungen und Mikrowellenentladungen bekannt. Verwiesen sei in diesem Zusammenhang auf den Artikel "The properties of a-C:H films deposited by plasma decomposition of C2H2", der Autoren J.W. Zou et al, Journal of Appl. Phys. 67 (1) 1989, sowie auf "Deposition and properties of diamond like carbon films, produced in microwave and radio frequency-plasma", A. Raveh, J.E. Klemberg-Sapieha, L. Martinu and M.R. Wertheimer, J. Vac. Sci. Technol. A 10(4), 1992, 1723.

In den letzten Jahren hat ebenfalls das Interesse an plasmapolymerisierten Schichten stark zugenommen. Auch hier liegen eine Anzahl Arbeiten über Abscheidungsprozesse mit den erwähnten Entladungsarten vor. Verwiesen sei auf die folgenden Literaturzitate: BMFT-Verbundprojekt "Plasmapolymerisation", VDI-Technologiezentrum "Physikalische Technologien", Düsseldorf 1993; J.T. Felts and A.D. Grubb, J. Vac. Sci. Technol A 10(4), 1675 (1992); J.T. Felts United States Patent, Patent Number: 4,888,199; Date of Patent: Dec. 19,. 1989.

Aus der DE 35 21 318 ist ein Verfahren und eine Vorrichtung zum Behandeln, insbesondere zum Beschichten von Substraten mittels einer Plasmaentladung bekannt. Dabei wird eine Folie nahe bei einem Magnetfeld im Dunkelraum der Entladung durchgeführt. Das Polymerisat wird zunächst auf einer Gegenelektrode abgeschieden, um dann auf der Folie deponiert zu werden.

Aus der DE 43 16 349 ist eine Innenbeschichtung eines Hohlkörpers mittels Mikrowellenentladung bekannt. Dabei geht es lediglich um das prinzipielle Verfahren und jedwelche Angaben, wie qualitativ gute Schichten hergestellt werden können, fehlen, wie auch insbesondere eine Charakterisierung der hergestellten Schichten.

Aus der Japanischen Patentanmeldung JP 32 02 467 ist die Überlagerung einer hochfrequenzinduzierten Plasmaentladung mit einem Mikrowellenplasmaentladung beschrieben, wobei die Herstellung von diamantähnlichen Beschichtungen angestrebt wird.

Ähnlich ist aus der JP 61 16 724 die Überlagerung von Magnetronsputtern und Mikrowellenentladungen bekannt.

Aus der EP 0 619 380 ist eine Anordnung bekannt, aufweisend mehrere Elektroden und Magnetrons, um an auf einer drehenden Vorrichtung angeordneten Substraten Mehrfachbeschichtungen vorzunehmen.

In der EP 0 293 662 wird die Beschichtung eines magnetischen Datenträgers mittels auf Kobalt basierenden Legierungen beschrieben sowie die Herstellung einer sehr harten Kohlenwasserstoffdeckschicht, wobei die beiden Beschichtungen in derselben Arbeitsatmosphäre durchgeführt werden.

Aus der EP 0 561 641 ist die Herstellung einer Schutzschicht auf einer magnetischen Diskette bekannt, welche durch Sputtern eines Kohlenstofftargets bei AC überlagertem DC Leistungseintrag erfolgt.

In der Japanischen Patentanmeldung 85240291 wird die Erzeugung eines Kohlenwasserstoffschutzfilmes beschrieben, wobei dieser Kohlenwasserstoffschutzfilm auf einem feromagnetischen dünnen Film angeordnet wird, welcher seinerseits auf einem Substrat angeordnet ist. Mittels der in diesem Dokument beschriebenen Verfahrensparameter werden sehr harte Schichten erzeugt.

Die EP 0 102 328 beschreibt das sogenannte "Cathode Sputtering" in einer Argonatmosphäre, um biokompatible, kohlenstoffhaltige Schichten abzuscheiden. Es liegt keine typische Plasmapolymerisation vor.

In der EP 0 428 358 wird die Beschichtung von Bändern bzw. Netzen mittels Magnetronsputtern beschrieben, wobei es sich bei den Substraten um Metallfolien bzw. Metallverbindungen und/oder Legierungen von Metallen handelt. Zur Diskussion steht die Erzeugung von äusserst anspruchsvollen Schichten im Zusammenhang mit optischen Eigenschaften.

Die EP 0 158 133 schliesslich beschreibt ein Manipulatorsystem für Vakuumkammern zur Mehrfachdeposition mit Verdampfungsquellen.

In der Vergangenheit wurde jede dieser Entladungsformen zur Oberflächenmodifizierung oder zur Beschichtung von beliebigen Materialien eingesetzt und für vereinzelte Anwendungen hochskaliert. Eine optimale Lösung, auch für flexible Schichten auf flexiblen Substraten, wurde in keiner der Schriften gefunden.

Die Aufgabe der vorliegenden Erfindung besteht darin, ein Verfahren, eine Anwendung des Verfahrens und eine Vorrichtung der eingangs genannten Art zu schaffen, welche stets einwandfreie Diffusionssperrschichten gewährleisten. Ein spezieller Aspekt der Aufgabenstellung der vorliegenden Erfindung besteht darin, eine optimale Prozessführung bei der Herstellung von Diffusionssperrschichten zur Behinderung bzw. Reduktion der Gas-, Wasserdampf- oder Aromastoffdurchlässigkeit auf flexiblen Substraten, wie Textilien oder Polymerfolien, -lamellen, -film festzulegen.

Erfindungsgemäss wird die gestellte Aufgabe bezüglich des Verfahrens nach dem Kennzeichen der Patentansprüche 1 bis 3 gelöst, bezüglich der Anwendung des Verfahrens nach dem Patentanspruch 10 und bezüglich der Vorrichtung nach dem Kennzeichen von Patentanspruch 12.

Der Prozessdruck für die erfindungsgemässen Verfahren wird vorzugsweise im Bereich von 3,6 · 10⁻³ bis 4,5 · 10⁻² mbar gehalten. Dabei hat es sich als zweckmässig erwiesen, den Druck in der Niederdruckplasmakammer vor Reaktionsbeginn auf ein Anfangsvakuum unterhalb des Prozessdrucks, insbesondere von weniger als 10⁻⁶ zu erniedrigen.

Nach einer bevorzugten Ausführungsform wird eine Substrathalterung geerdet oder mit einem Bias von bis zu 40 W versorgt. Die Substrattemperatur liegt zweckmässig bei weniger als 50°C.

Beim Einsatz einer Magnetron-Zerstäubungsquelle werden die Kohlenstoffteilchen vorteilhaft in einer Argonatmosphäre gesputtert.

Plasmapolymerisierte Kohlenwasserstoffschichten werden vorzugsweise mit einem Gemisch aus wenigstens einem reaktiven Kohlenwasserstoffgas und wenigstens einem Edelgas erzeugt, insbesondere mit Acethylen als Kohlenwasserstoffmonomer in einer inerten Gasphase mit Helium und/oder Argon als Edelgas.

Die Verfahren zum Abscheiden von Diffusionssperrschichten werden besonders vorteilhaft angewendet zur Herstellung von flexiblen funktonalen Schichten von 19- 508 nm Dicke. Diese Schichten erniedrigen insbesondere die Gas-, Wasserdampf- oder Aromastoffdurchlässigkeit bei Verpackungsmaterialien, welche beispielsweise aus Polypropylen, Polyethylen, Polyethylenterephtalat, Polyvinylchlorid oder Polystyrol bestehen.

Mit derselben erfindungsgemässen Niederdruckplasmakammer zum Durchführen von Plasmaprozessen können zwei oder mehrere unterschiedliche Plasmaprozessarten für die Beschichtung von Oberflächen eines Substrates durchgeführt werden. Im speziellen wird eine Niederdruckplasmakammer für den kontinuierlichen oder gepulsten Betrieb vorgeschlagen, die mindestens zwei Prozesseinrichtungen aufweist, ausgewählt aus der nachfolgenden Liste:
- Mikrowellenentladung,
- Gleichstromentladung,
- Hochfrequenzentladung,
- Gleichstrom- und/oder Hochfrequenzmagnetronzerstäubung.

Die Entladungsgeometrie einer Niederdruckplasmakammer bestimmt in der Regel neben dem Gasdruck und der Gasart die Elektronentemperatur des Plasmas, sowie die elektrische Feldstärke, unabhängig von der zugeführten Leistung. Als Folge davon hängen die Eigenschaften der abzuscheidenden Schichten auf dem Substrat von der Geometrie eines Plasmareaktors ab. Die Kombination der verschiedenen Entladungsarten, wie oben vorgeschlagen, an ein und demselben Reaktor ermöglicht es deshalb, diesen entscheidenden Parameter zu eliminieren.

Der erfindungsgemäss vorgeschlagene Typ einer Niederdruckplasmakammer ist derart konzipiert, dass die verschiedenen Entladungsarten bei reproduzierbaren, definierten Bedingungen direkt verglichen werden können. Ein Ziel bei der Applikation von funktionalen Schichten liegt darin, die Funktion der Prozessverfahren zu erforschen und zu entwickeln. Es werden insbesondere die gegenwärtig am vielversprechendsten Techniken, wie Mikrowellenentladungen, Gleichstromentladungen, Hochfrequenzentladungen und Gleichstrom- und Hochfrequenz-Magnetronzerstäubungen in dem erfindungsgemäss beschriebenen Niederdruckplasmareaktor untersucht, wobei die oben erwähnte Mikrowellenquelle ebenfalls zu einer ECR-Quelle (Elektron Zyklotron Resonanz) ausgebaut werden kann.

Das Konzept von bevorzugten Ausführungsformen der erfindungsgemässen Niederdruckplasmakammer liegt, neben den stets erreichbaren, in den folgenden Eigenschaften:
- Entladungseinrichtungen unabhängig voneinander, getrennt ansteuerbar und betreibbar,
- Möglichst hohe Symmetrie,
   Mittel zum Erreichen eines sehr guten Anfangsvakuum von weniger als 10⁻⁶ mbar
- Senkrechtstehende Substrathalterung, welche unter Beibehaltung der Vakuumbedingungen von einer Plasmaquelle zur anderen bewegbar ist und gegebenenfalls gedreht werden kann.
- Seitlich angeordnete Gleichstrom-/Hochfrequenzquelle mit und ohne Magnetfeldunterstützung (Permanentmagnet), und
- seitlich angeordnetes Mikrowellensystem mit und ohne Magnetfeldunterstützung (Elektro- oder Permanentmagnet-Elektron Zyklotron Resonanz (ECR)).

Die erfindungsgemässe Niederdruckplasmakammer eignet sich insbesondere zum Beurteilen von mittels Plasmapolymerisation auf einem Substrat aufgetragenen Schichten, wie beispielsweise dem Beschichten von den neuerdings zur Verwendung gelangenden PET-Behältern. Bekanntlich ist ja bei den PET-Flaschen die Permeabilität von Gasen (CO₂, O₂ und Aromastoffe) zu hoch, weshalb deren Lagerfähigkeit beschränkt ist. Geeignete Diffusionssperrschichten, auch Barriereschichten genannt, sollen diesen Gasaustausch behindern bzw. reduzieren. Als Beispiele seien sogenannte plasmapolymerisierte amorphe Kohlenwasserstoffschichten erwähnt, welche dadurch erhalten werden, dass in eine Plasmakammer z.B. Acetylengas als Reaktivgas eingeführt wird.

Mittels der erfindungsgemässen Niederdruckplasmakammer ist es möglich, Aussagen über Entladungscharakteristiken, Schichteigenschaften und Abscheiderate zu erhalten, um eine optimale Prozessführung definieren zu können.

Mit der erfindungsgemässen Niederdruckplasmakammer durchgeführte Versuchsreichen ergeben eine vorzugsweise geeignete Prozessführung für die Herstellung von der dünnen Schichten von vorzugsweise planen Flächen, welche als Barriereschichten den Durchgang von Gasen, Wasserdampf und weiteren organischen und/oder anorganischen Substanzen behindern bzw. reduzieren.

Damit können auf möglichst planen Flächen sehr dünne Schichten von beispielsweise 20 nm erhalten werden. Der Vorteil dieser Schichten liegt darin, dass sie aus definierten, einfachen Kohlenwasserstoffteilchen aufgebaut werden, und somit ein kleines Risiko für unerwünschte Wechselwirkungen mit dem beschichteten Substrat sowie dem kontaktierten Medium (Migration von organischen Verbindungen) besteht. Mittels des erfindungsgemäss vorgeschlagenen Verfahrens ist es insbesondere möglich auf starren oder quasi starren Substraten, wie Metallen, Keramik und dgl. die erwähnt sehr dünnen Schichten aufzutragen, wobei selbstverständlich auch flexible oder quasi flexible Substrate beschichtbar sind, wie beispielsweise Medikamente, Kosmetika, Tabak, oder generell Substrate in der Medizinaltechnik.

Aufgrund der Eignung der Plasmapolymerisation für die Beschichtung von polymeren Materialien oder genereller von flexiblen Substraten und aufgrund der Möglichkeit der Festlegung optimaler Prozessführungen mittels der erfindungsgemäss vorgeschlagenen Niederdruckplasmakammer wird entsprechend ein Verfahren zum Beschichten von polymeren Materialien mit funktionalen Schichten vorgeschlagen. Insbesondere vorgeschlagen wird die optimale Prozessführung bei der Herstellung von dünnen Diffusionssperrschichten auf Polymerfolien, -lamellen, -filme -rohre, -schläuche, -behälter und dgl.

Polymere Werkstoffe, wie insbesondere Polymerfolien, -lamellen, -filme und dgl. können mittels einer DC-Magnetronquelle durch Sputtern bzw. mittels Magnetronentladung oder mittels einer Mikrowellenentladung zum Erzeugen von funktionalen Schichten, wie beispielsweise dünnen Diffusionssperrschichten, beschichtet werden.

Die Erfindung wird nun anschliessend beispielsweise und unter Bezug auf die beigefügten Figuren sowie die nachfolgenden Versuchsbeispiele näher erläutert.

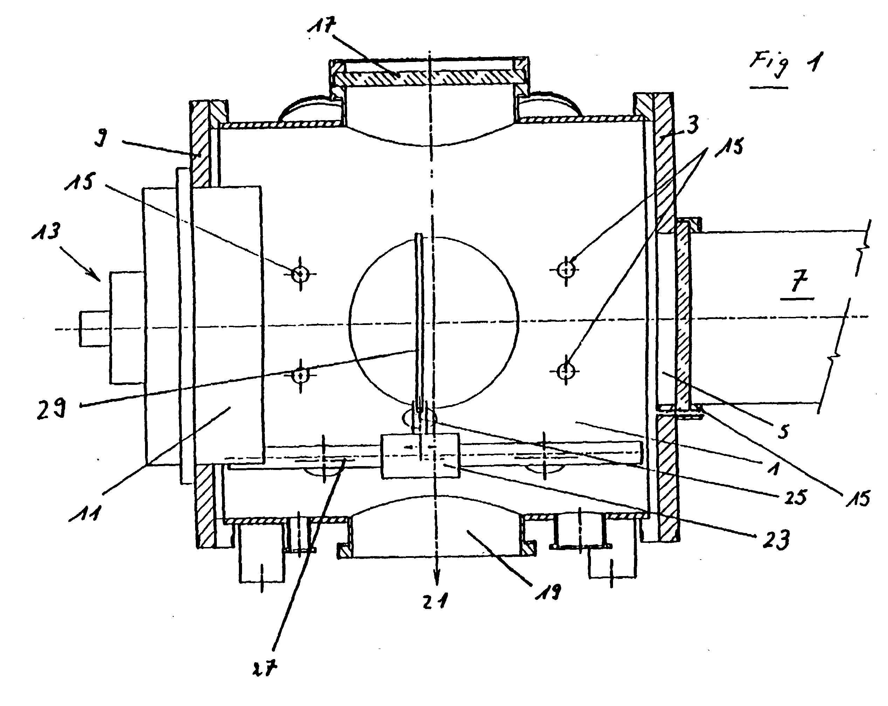

Die beigefügte Figur 1 zeigt im Schnitt eine erfindungsgemässe Niederdruckplasmakammer, umfassend ein RF/DC-Magnetron sowie eine Mikrowellenquelle.

Die Niederdruckplasmakammer 1 umfasst in den beiden sich gegenüberliegenden Plasmawandungen 3 und 9 je eine unterschiedliche Einrichtung für das Erzeugen unterschiedlicher Entladungsarten. So ist in einer Oeffnung 5 der Wandung 3 eine Mikrowellenquelle 7 vorgesehen, um im Innern der Kammer 1 ein Mikrowellenplasma zu erzeugen. Auf der der Wandung 3 gegenüberliegenden Seite, in der Wandung 9, ist in einer entsprechenden Oeffnung 11 ein RF/DC-Magnetron 13 vorgesehen, für das Erzeugen von Magnetronplasmen in der Kammer 1.

Für das Einführen von Reaktivgasen sind sowohl in der Kammerwandung als auch um das Mikrowellenfenster 5 herum Gaseinlassöffnungen 15 vorgesehen. Falls beispielsweise eine plasmapolymerisierte amorphe Kohlenwasserstoffschicht auf einem Substrat 29 zu erzeugen ist, wie beispielsweise auf einer PET-Flasche, wird durch mindestens eine der Gaseinlassöffnungen Prozessgas (zum Beispiel Acetylengas) in die Niederdruckplasmakammer 1 eingeführt.

Am Boden der Niederdruckplasmakammer 1 ist eine Oeffnung 19 vorgesehen, welche zu einer Vakuumpumpe 21 führt, für das Erzeugen eines Vakuums im Innern der Plasmakammer, wie beispielsweise einem Plasma von ca. 10⁻² mbar. Die an der gegenüberliegenden Deckseite vorgesehene Oeffnung kann mittels einer Abdeckung 17 verschlossen werden.

Um ein Substrat 29 im Innern der Niderdruckplasmakammer 1 anzuordnen ist eine schienenartige Unterlage 27 vorgesehen, auf welcher längsverschieblich die Substrathalterung 23 vorgesehen ist. Die Substrathalterung 23 weist eine um eine Rotationsachse rotierbare Einrichtung 25 auf, auf welche um eine senkrechte Achse rotierbar das Oberflächen zu behandelnde Substrat 29 angeordnet werden kann. Um eine möglichst homogene und uniforme Oberflächenbehandlung bei einem nichtplanen Substrat zu ermöglichen, ist das Substrat vorteilhafterweise um die Vertikalachse rotierbar in der Plasmakammer 1 angeordnet. In der dargestellten Figur ist das Substrat 29 stiftartig dargestellt, selbstverständlich kann es sich dabei um ein x-beliebiges Substrat, wie beispielsweise eine PET-Flasche, einen zu beschichtenden Waver handeln, der auf der Substrathalterung 23 bzw. 25 angeordnet werden kann.

Ein Substrat 29, angeordnet in der Niederdruckplasmakammer 1, kann mittels den verschiedendsten Entladungsarten beschichtet bzw. behandelt werden. Um beurteilen zu können, welche der gewählten Entladungsarten für das gewählte Substrat und die gewählte Schicht, wie beispielsweise eine plasmapolymerisierte Kohlenwasserstoffschicht, das optimale Verfahren darstellt, kann dies anhand mehrerer Versuche an gleichen Substraten in ein- und derselben Niederdruckplasmakammer 1 festgestellt werden. Selbstverständlich sind auch Mehrfachbeschichtungen mit oder ohne Kombination der verschiedenen Entladungsarten möglich.

Eine typische Beschichtung von Verpackungsfolien oder PET-Flaschen ist beispielsweise bei den folgenden Prozessbedingungen möglich:
- Druck:: 8 x 10⁻³ - 3 x 10⁻² mbar
- Gase:: Kohlenwasserstoffe (z.B. Acetylen) oder Gemische derselben mit Helium oder Argon,
- Energien:: 400 Watt - 1000 Watt Gleichstrom/Hochfrequenz/Mikrowelle
- Vorlegespannung:: 0 Watt - 40 Watt Hochfrequenz
- Substrate:: Siliziumwaver, Kunststoffolien (z.B. PET, Polyetylen, Polypropylen)
- Temperatur:: < 50°C auf Substrat

Unter den erwähnten Bedingungen sind mit vergleichbarem Erfolg in der Praxis brauchbare Ergebnisse erzielbar, wie dies mittels Analysen feststellbar ist.

Mittels der erfindungsgemässen in Niederdruckplasmakammer 1 wurden optimale Prozessbedingungen für die Herstellung von dünnen und sehr dünnen Diffusionssperrschichten auf dünnen Polymerfolien eruiert. Dünne Polymerfolien wurden als Beispiele gewählt, vorstellbar ist aber die Beschichtung von allen denjenigen Materialien mittels einer erfindungsgemäss definierten Plasmakammer, bei welchen eine Diffusionssperrschicht die Gas-, Wasserdampf- oder Aromastoffdurchlässigkeit zum Schutze des verpackten Inhaltes (Polypropylen-, Polyethylen-, Polyethylenterephthalat-, Polyvinylchlorid-, Polystyrolfolien, etc.) sowie zum Schutze des Substrates (Migrations- oder Korrosionsschutz sowie elektrische Isolation) herabsetzen soll. Insofern ist es auch denkbar, metallische und teilweise auch keramische oder glasartige (z.B. Sensoren, Sender, Implantate, etc.) sowie generell polymerartige Werkstoffe gemäss den für die Beschichtung von dünnen Polymerfolien eruierten, optimalen Prozessbedingungen zu beschichten.

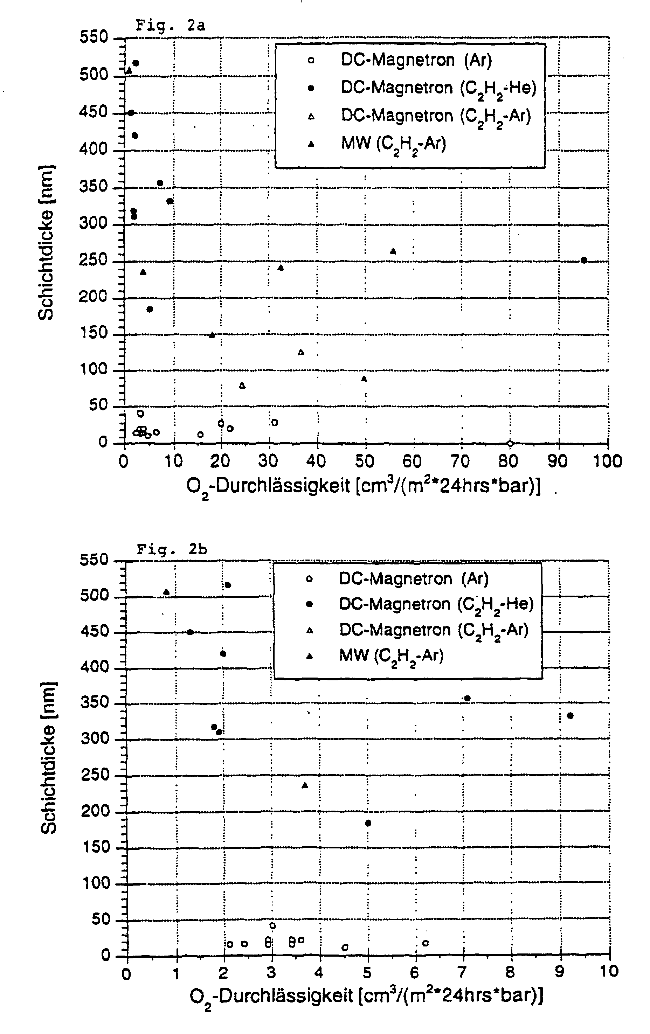

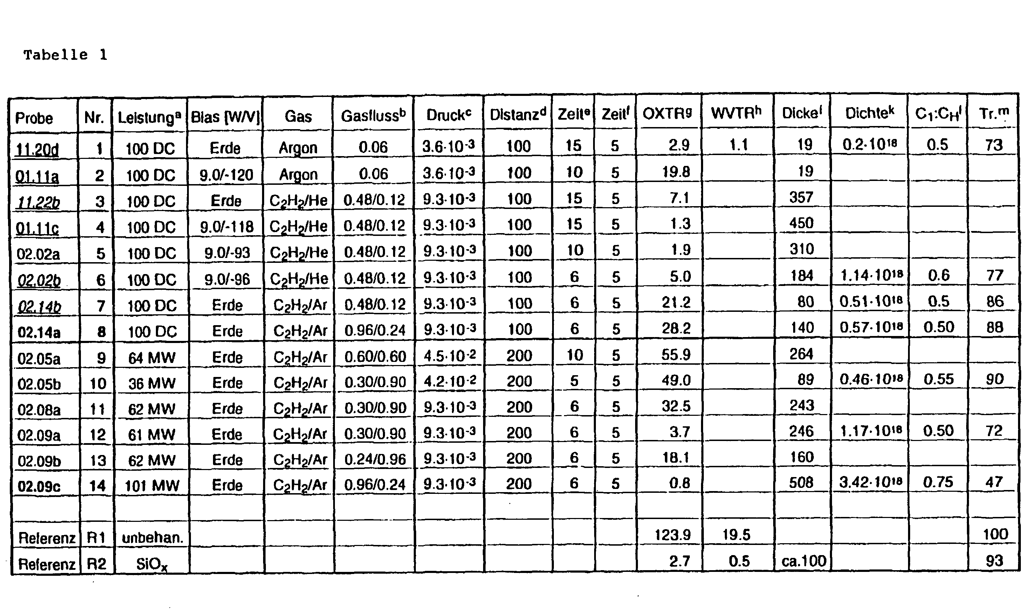

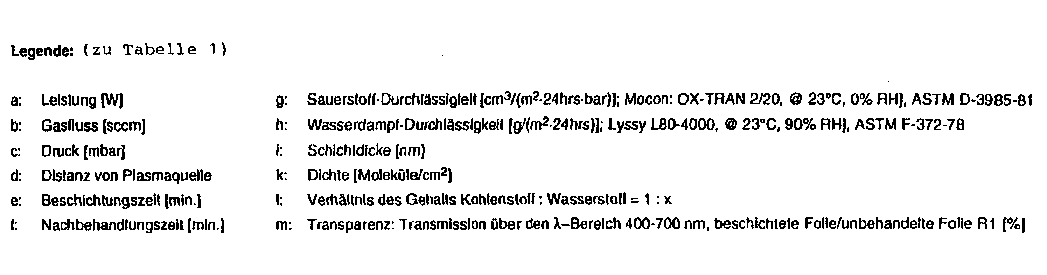

In den nachfolgenden beiden Fig. 2a und 2b und der Tabelle sind ausgewählte Beschichtungen zusammengestellt bzw. dargestellt. Mit einer DC-Magnetron-Zerstäubungsquelle (DC) wurden in einer Argon(Ar)-Atmosphäre Kohlenstoffteilchen von einem Kohlenstofftarget auf eine 12 µm dünne PET (Polyethylenterephthalat)-Folie gesputtert. Die ca. 20 nm dünne Schicht weist sehr gute Diffusionssperreigenschaften bezüglich Sauerstoff und Wasserdampf auf. Die Schicht hat nahezu keine inneren Spannungen, was bei der Plastikfolie durch eine Beobachtung der Krümmung leicht analysiert werden kann. Der Kohlenstoffgehalt ist etwa doppelt so hoch wie der Wasserstoffgehalt. Der Wasserstoff stammt aus dem restlichen Wassergehalt in der Plasmaatmosphäre. Mit gezielten Experimenten wird die Korrelation der Permeationseigenschaften und des Wasserstoffgehaltes dieser Beschichtungen analysiert.

Generell kann ausgesagt werden, dass die mit dem DC-Magnetron-Argon gesputterten Schichten qualitativ hochwertige Kohlenwasserstoffschichten sind und sich besonders eignen für Anwendungen, bei denen möglichst plane Flächen mit einer sehr dünnen Schicht von ca. 20 nm beschichtet werden müssen. Die niedrige Depositionsrate beschränkt diese Methode auf starre, quasi starre Substrate oder auf Verpackungen für Produkte mit höherer Wertschöpfung, z.B. Medikamente, Kosmetik, Tabak, Medizinaltechnik. Der Vorteil dieser Schichten liegt darin, dass sie aus definierten, einfachen Kohlenstoffteilchen aufgebaut werden, und ein kleines Risiko für unerwünschte Wechselwirkungen mit dem Substrat sowie dem kontaktierenden Medium (Migration von organischen Verbindungen) besteht. Die Erzeugung von sehr dünnen Schichtdicken und gleichzeitig Erzielung eines hohen Durchlässigkeitssperreffektes ergibt sich aus den beiden beigefügten Figuren 2a und 2b, wobei Figur 2b auszugsweise denjenigen Bereich aus Figur 2a darstellt, welcher eine O₂-Durchlässigkeit von 0 - 10 [cm³/(m²*24hrs*bar)] umfasst.

Bei der Verwendung von einem optimierten Gemisch aus Azethylen (C₂H₂)- und Helium (He) - Gas wurde mit der DC-Magnetronentladung ebenfalls eine gute plasmapolymerisierte Diffusionssperrschicht entwickelt. Die Permeationseigenschaften sind vergleichbar mit der oben beschriebenen Beschichtung, zudem ist die Abscheiderate ca. 20 mal höher. Wird die geerdete Substrathalterung mit einem Hochfrequenz-Bias von 9 Watt und -93 bis -120 Volt versorgt, resultiert eine noch höhere Abscheiderate mit einer positiven Wirkung auf die Schichteigenschaften. Bei der mit Ar-C-gesputterten Schicht wirkt sich das negative Potential negativ auf die Permeationseigenschaften aus (Vergleich Proben-Nr. 1,2 und 6,7). Beim Azethylen/-Helium-Gas-Gemisch wurde die Beschichtungsdauer variiert, um dünnere Schichten zu erhalten (Proben-Nr. 4,5,6).

Der Vergleich zwischen einem entsprechenden Azethylen/Heliumund einem Azethylen/Argon-Gemisch erfolgt über die Beschichtungen 3,6 und 7. Die Beschichtungsrate ist beim Azethylen/Helium-Gemisch doppelt so hoch wie beim Azethylen/Argon-Gemisch. Zudem ist bei vergleichbaren Bedingungen die Sauerstoff-Durchlässigkeit bei der mit dem Azethylen/Argon-Gemisch hergestellten Schicht markant schlechter als beim Gemisch mit dem Edelgas Helium. Weder die Beschichtungsdauer bzw. die Schichtdicke, hoch die Wahl des Bias hat eine so deutliche Verschlechterung der Permeationseigenschaft zur Folge.

Wie aus Figur 2a ersichtlich ist, liegen die Beschichtungen der DC-Magnetronentladung mit dem C₂H₂-He-Gemisch zwar im Bereich der höheren Schichtdicke (höhere Beschichtungsrate), sind aber den oben beschriebenen Ar-C-gesputterten Schichten bezüglich Diffusionssperrwirkung ebenbürtig. (Der positive Einfluss des negativen Bias ist ebenfalls deutlich ersichtlich).

Bei diesen Versuchsbedingungen ist in demselben Reaktor ein Vergleich mit der höher ionisierenden und dissoziierenden Mikrowellen-Entladung (MW) angezeigt. Bei identischen Gasbedingungen (Gasfluss, Gasdruck) ist die Diffusionssperrwirkung bei der mit der MW-Entladung erzeugte Schicht signifikant besser als die mit Hilfe des DC-Magnetrons erzeugte Schicht (Proben 8 und 14). Die Schicht ist bei gleicher Beschichtungszeit ca. 3,7 mal dicker, was positiv mit einer deutlich höheren Abscheiderate zu werten ist. Zudem wird erwartet, dass sich die Herabsetzung der Schichtdicke nicht nur negativ auf die Permeations-Eigenschaften auswirkt, weil die Flexibilität einer dünnen Schicht höher sein sollte.

Für die mit der Mikrowellenentladung hergestellten plasmapolymerisierten C₂H₂-Ar-Schichten hängt die Diffusionssperrwirkung stark von der ins Plasma eingebrachten Leistung und der damit verbundenen dissoziativen und ionisierenden Wirkung auf das gewählte Gasgemisch ab. Der signifikant höhere Wasserstoffgehalt und die hohe Dichte dieser plasmapolymerisierten Schicht (Nr. 14) schlagen sich in der hervorragenden Diffusionssperrwirkung dieser Schicht nieder.

Erste Flexibilitätsstudien zeigen, dass die plasmapolymerisierte C₂H₂-He-Schicht (DC-Magnetron) und C₂H₂-Ar-Schicht (Mikrowellenentladung) signifikant dehnbarer als die Ar-C-Schicht (DC-Magnetron-C-Ar) oder der Referenzfolie R1 (SiOₓ auf PET sind).

DC-Magnetron-C₂H₂-He sowie Mikrowellenentladung-C₂H₂-Ar-Beschichtungsverfahren eignen sich deshalb zur Beschichtung von flexiblen, grossflächigen Substraten, wie beispielsweise Polymerfolien, Lebensmittelverpackungen, Textilien und dgl. Hinzu kommt, dass die Depositionsrate mindestens 20x höher ist als beim DC-Magnetron-C-Ar-Beschichtungsverfahren. Die Magnetronentladung (direktive Entladung und gut hoch skalierbar) ist zur Beschichtung von grossflächigen, planen Substraten (Folien welche abgerollt werden) angezeigt, währenddem die Mikrowellenentladung (globale Entladung) bei der Beschichtung von dreidimensionalen Behältern (Rohre, Flaschen, Behälter, etc.) vorzuziehen ist. Dabei ist allerdings zu bemerken, dass sowohl bei Magnetronentladung wie auch bei Mikrowellenentladung die plasmapolymerisierte Kohlenwasserstoffschicht nicht nur mittels des beispielsweise ausgewählten Azethylengases erreicht werden kann, sondern ebenfalls andere Kohlenwasserstoffgasarten oder Gemische davon verwendet werden können, wie insbesondere auch Kohlenwasserstoffmonomere, wie sie in der Polymerherstellung Verwendung finden. Derselbe Hinweis gilt auch für die verwendeten Edelgase Helium und Argon, wo grundsätzlich auch andere Edelgase verwendet werden können.

In den vorab beschriebenen Versuchsbeispielen geht es nicht primär darum, das oder die ausgewählten Gasgemische, wie beispielsweise Azethylen/Helium oder Azethylen/Argon als prozessoptimale Gasgemische darzustellen, sondern vielmehr soll mit den vorab beschriebenen Beispielen dargelegt werden, dass es möglich und vorteilhaft ist, funktionale Schichten, insbesondere auf Polymerfolien abzulagern, welche einerseits ausreichende Diffusionssperreigenschaften aufweisen und andererseits auch gute mechanische Eigenschaften aufweisen, so dass beispielsweise die Flexibilität, die Reissfestigkeit, Verschweissbarkeit, etc. der beschichteten Folie nicht negativ beeinflusst werden. Selbstverständlich sind auch andere als die gewählten Gasgemische geeignet für das Herstellen von plasmapolymerisierten Kohlenwasserstoffschichten auf irgendwelchen Substraten, welche hochvakuumtauglich sind, wie insbesondere auf dünnen Polymerfolien. Obwohl die Beschichtungen kontinuierlich bzw. mit nicht-gepulster Entladung erzeugt worden sind, können die erfindungsgemäss vorgeschlagenen Entladungsverfahren selbstverständlich auch gepulst bzw. diskontinuierlich betrieben werden.

Bei der eingangs beschriebenen und in der Fig.1 dargestellten Anordnung handelt es sich selbstverständlich nur um ein Beispiel. Mit Hilfe anderer Einrichtungen, wie beispielsweise einer Elektronstrahlkanone/-Ionenstrahlkanone oder eines Tiegelverdampfers, werden andere Oberflächenbehandlungsarten in ein- und derselben Plasmakammer für die Beurteilung der Prozessführung durchgeführt. Auch geht es nicht zwingend um die Beurteilung von dünnen funktionalen Schichten, sondern es ist durchaus auch möglich funktionale Oberflächenbehandlungen, wie Modifizierung (Aetzen, Reinigen, Benetzbarkeit, Adhäsion, etc.), wie auch Beschichtung (dünne Filme) von Substraten mittels unterschiedlichen Prozessführungen zu beurteilen. Wesentlich ist, dass die verschiedenen Einrichtungen getrennt voneinander ansteuerbar und gleichzeitig betreibbar sind.

## Patentansprüche

1. Verfahren zum Abscheiden von Diffusionssperrschichten mit einem Kohlenwasserstoffgerüst durch kontinuierliche, diskontinuierliche und/oder gepulste Entladung in einer Niederdruckplasmakammer (1) mit wenigstens je einem Gleichstrom- und/oder Hochfrequenz-Magnetron,
**dadurch gekennzeichnet, dass**
gleichzeitig durch dieselbe Magnetronentladung
- wenigstens eine Diffusionssperrschicht aus einem Gasgemisch von Kohlenwasserstoff und Edelgas mittels Plasmapolymerisation auf dem Substrat (29) abgeschieden, und
- Teilchen von einer Magnetronzerstäubungsquelle (13) gesputtert und in der Schicht auf dem Substrat (29) eingebunden werden,
wobei die Entladung mit einer Leistung im Bereich von 100 W bis 1000 W erfolgt.

2. Verfahren zum Abscheiden von Diffusionssperrschichten mit einem Kohlenwasserstoffgerüst durch kontinuierliche, diskontinuierliche und/oder gepulste Entladung in einer Niederdruckplasmakammer (1) mit einer Mikrowellenentladung und einem Magnetron (13),
**dadurch gekennzeichnet, dass**
in einem Gasgemisch von Kohlenwasserstoff und Edelgas mittels einer Mikrowellenentladung und gleichzeitig in Kombination mit wenigstens je einer Magnetronzerstäubungsquelle (13), welche ein Target und/oder eine Magnetronentladung zur Plasmapolymerisation - mit oder ohne Magnetfeld - umfasst, wenigstens eine Plasmapolymerisationsschicht aus Kohlenwasserstoff abgeschieden wird, wobei die Entladung mit einer Leistung im Bereich von 36 W bis 1000 W erfolgt.

3. Verfahren zum Abscheiden von Diffusionssperrschichten mit einem Kohlenwasserstoffgerüst durch kontinuierliche, diskontinuierliche und/oder gepulste Entladung in einer Niederdruckplasmakammer (1), indem aus einem Gasgemisch aus Kohlenwasserstoff und Edelgas mittels einer Mikrowellenentladung, mit oder ohne Magnetfeld, eine Plasmapolymerisationsschicht aus Kohlenwasserstoff abgeschieden wird,
**dadurch gekennzeichnet, dass**
die Entladung mit einer Leistung im Bereich von 36 W bis 1000 W erfolgt.

4. Verfahren nach einem der Ansprüche 1 bis 3, **dadurch gekennzeichnet, dass** der Prozessdruck im Bereich von 3,6 · 10⁻³ bis 4,5 · 10⁻² mbar gehalten wird.

5. Verfahren nach einem der Ansprüche 1 bis 4, **dadurch gekennzeichnet, dass** der Druck in der Niederdruckplasmakammer (1) vor Reaktionsbeginn auf ein Anfangsvakuum unterhalb des Prozessdrucks, insbesondere von weniger als 10⁻⁶ mbar, erniedrigt wird.

6. Verfahren nach einem der Ansprüche 1 bis 5, **dadurch gekennzeichnet, dass** eine Substrathalterung (23) geerdet oder mit einem Bias bis 40 W versorgt wird.

7. Verfahren nach einem der Ansprüche 1 bis 6, **dadurch gekennzeichnet, dass** die Substrattemperatur weniger als 50° C beträgt.

8. Verfahren nach einem der Ansprüche 1 bis 6, **dadurch gekennzeichnet, dass** die plasmapolymerisierte Kohlenwasserstoffschicht mit einem Gemisch aus wenigstens einem reaktiven Kohlenwasserstoffgas und wenigstens einem Edelgas erzeugt wird.

9. Verfahren nach Anspruch 8, **dadurch gekennzeichnet, dass** als Kohlenwasserstoffgas Acethylen, als Edelgas Helium und/oder Argon eingeleitet wird.

10. Anwendung des Verfahrens nach einem der Ansprüche 1 bis 9 zur Herstellung von flexiblen funktionalen Schichten von 19 - 508 nm Dicke.

11. Anwendung des Verfahrens nach Anspruch 10 zur Erniedrigung der Gas-, Wasserdampf- oder Aromastoffdurchlässigkeit bei Verpackungsmaterialien, insbesondere bestehend aus Polypropylen, Polyethylen, Polyethylenterephthalat, Polyvinylchlorid oder Polystyrol.

12. Niederdruckplasmakammer (1) zum Durchführen des Verfahrens nach einem der Ansprüche 1 bis 9,
**gekennzeichnet, durch**
- wenigstens je eine kontinuierlich, diskontinuierlich und/oder gepulst betriebene Gleichstrom- bzw. Hochfrequenz-Magnetronentladung, und/oder eine Gleichstrom- und/oder Hochfrequenz-Magnetronzerstäubungsquelle (13) mit einem Kohlenstofftarget, sowie
- wenigstens eine kontinuierlich, diskontinuierlich und/oder gepulst betriebene Mikrowellenentladung (7), mit oder ohne Magnetfeld.

13. Niederdruckplasmakammer (1) nach Anspruch 12, **dadurch gekennzeichnet, dass** die Entladungseinrichtungen (7,13) voneinander unabhängig ansteuerbar und betreibbar sind.

14. Niederdruckplasmakammer (1) nach Anspruch 12 oder 13, **dadurch gekennzeichnet, dass** zwischen den Entladungseinrichtungen (7,13) eine Substrathalterung (23) vorgesehen ist, welche in Richtung der Einrichtungen (7,13) verschiebbar und vorzugsweise senkrecht stehend angeordnet ist.

15. Niederdruckplasmakammer (1) nach einem der Ansprüche 12 bis 14, **dadurch gekennzeichnet, dass** die Mikrowellenquelle (7) zu einer magnetfeldunterstützenden Quelle, insbesondere zu einer ECR-Quelle, ausbaubar ist.

16. Niederdruckplasmakammer (1) nach einem der Ansprüche 12 bis 15, **dadurch gekennzeichnet, dass** an mindestens einer Entladungseinrichtung (7,13) und/oder an der Plasmakammerwandung (3) Mittel zum Erzeugen eines Magnetfeldes vorgesehen sind, insbesondere Permanentmagnete.

## Claims

1. Procedure for depositing diffusion barrier layers with a hydrocarbon structure by way of continuous, discontinuous and/or pulsed discharge in a low pressure plasma chamber (1) with at least one direct current and/or high frequency magnetron,
**characterised in that**,
simultaneously through the same magnetron discharge
- at least one diffusion barrier layer of a gas mixture of hydrocarbon and natural gas is deposited by means of plasma polymerisation on the substrate (29) and
- particles of a magnetron sputtering source (13) are sputtered and integrated into the layer on the substrate (29),
where the discharge takes place with power in the range from 100W to 1000W.

2. Procedure for depositing diffusion barrier layers with a hydrocarbon structure by way of continuous, discontinuous and/or pulsed discharge in a low pressure plasma chamber (1) with a microwave discharge and a magnetron (13),
**characterised in that**,
in a gas mixture of hydrocarbon and noble gas by means of a microwave discharge and simultaneously in combination with at least one magnetron sputtering source (13) which comprises a target and/or a magnetron discharge for plasma polymerisation - with or without magnetic field -, at least one plasma polymerisation layer of hydrocarbon is deposited, where the discharge takes place with an power in the range from 36W to 1000W.

3. Procedure for depositing diffusion barrier layers with a hydrocarbon structure by way of continuous, discontinuous and/or pulsed discharge in a low pressure plasma chamber (1), in which a plasma polymerisation layer of hydrocarbon is deposited from a gas mixture of hydrocarbon and noble gas by means of a microwave discharge,
**characterised in that**,
the discharge takes place with power in the range from 36W to 1000W.

4. Procedure according to any of claims 1 to 3,
**characterised in that** the process pressure is maintained in the range from 3.6 . 10⁻³ to 4.5 . 10⁻² mbar.

5. Procedure according to any of claims 1 to 4,
**characterised in that** the pressure in the low pressure plasma chamber (1) is lowered before the start of the reaction to a starting vacuum below the process pressure, in particular less than 10⁻⁶ mbar.

6. Procedure according to any of claims 1 to 5,
**characterised in that** a substrate mounting (23) is earthed or supplied with a bias of 40W.

7. Procedure according to any of claims 1 to 6,
**characterised in that** the substrate temperature is less than 50 °C.

8. Procedure according to any of claims 1 to 6,
**characterised in that** the plasma polymerised hydrocarbon layer is produced with a mixture of at least one reactive hydrocarbon gas and at least one noble gas.

9. Procedure according to claim 8, **characterised in that** as a hydrocarbon gas acetylene is introduced, as noble gas helium and/or argon.

10. Application of the procedure according to any of claims 1 to 9 for the manufacture of flexible functional layers of a thickness of 19 - 508 nm.

11. Application of the procedure according to claim 10 to reduce the gas, water vapour or aroma permeability in packaging materials, in particular made from polypropylene, polyethylene, polyethylene terephthalate, polyvinyl chloride or polystyrene.

12. Low pressure plasma chamber (1) for performance of the procedure according to any of claims 1 to 9,
**characterised by**
- at least one continuous, discontinuous and/or pulsed operated direct current or high frequency magnetron discharge, and/or a direct current and/or high frequency magnetron sputtering source (13) with a carbon target, and
- at least one continuous, discontinuous and/or pulsed operated microwave discharge (7) with or without a magnetic field.

13. Low pressure plasma chamber (1) according to claim 12, **characterised in that** the discharge devices (7,13) can be controlled and operated independently of each other.

14. Low pressure plasma chamber (1) according to claim 12 or 13, **characterised in that** between the discharge devices (7,13) is provided a substrate mounting (23) which is movable in the direction of the devices (7, 13) and preferably arranged standing vertically.

15. Low pressure plasma chamber (1) according to any of claims 12 to 14, **characterised in that** the microwave source (77) can be extended to a source supporting a magnetic field, in particular an ECR source.

16. Low pressure plasma chamber (1) according to any of claims 12 to 15, **characterised in that** on at least one discharge device (7,13) and/or the plasma chamber wall (3) are provided means to generate a magnetic field, in particular permanent magnets.

## Revendications

1. Procédé de dépôt de couches de barrage de diffusion au moyen d'un bâti à hydrocarbures par décharge continue, discontinue et/ou puisée dans une chambre (1) de plasma à basse pression qui comporte au moins un magnétron à courant continu et/ou à haute fréquence,
**caractérisé en ce que**:
simultanément avec cette décharge de magnétron:
- au moins une couche de barrage de diffusion est déposée sur le substrat (29) à partir d'un mélange gazeux d'hydrocarbure et de gaz noble par polymérisation plasma, et
- des particules d'une source (13) de pulvérisation à magnétron sont pulvérisées et sont intégrées dans la couche sur le substrat (29),
la décharge étant effectuée à une puissance comprise dans une plage de 100 W à 1000 W.

2. Procédé de dépôt de couches de barrage de diffusion au moyen d'un bâti à hydrocarbures par décharge continue, discontinue et/ou pulsée dans une chambre (1) de plasma à basse pression qui comporte au moins une décharge micro-ondes et un magnétron (13)
**caractérisé en ce que**
au moins une couche de polymérisation par plasma consistant en un hydrocarbure est déposée, dans un mélange gazeux d'hydrocarbure et de gaz noble, au moyen d'une décharge à micro-ondes et simultanément en combinaison avec au moins soit une source (13) de pulvérisation magnétron qui inclut une cible et/ou une décharge de magnétrons pour polymérisation plasma - avec ou sans champ magnétique, la décharge étant effectuée à une puissance comprise dans une plage de 36 W à 1000 W.

3. Procédé de dépôt de couches de barrage de diffusion au moyen d'un bâti à hydrocarbures par décharge continue, discontinue et/ou pulsée dans une chambre (1) de plasma à basse pression dans laquelle une couche de polymérisation par plasma consistant en un hydrocarbure est déposée à partir d'un mélange gazeux d'hydrocarbure et de gaz noble au moyen d'une décharge micro-ondes avec ou sans champ magnétique,
**caractérisé en ce que**
la décharge est effectuée à une puissance comprise dans une plage de 36 W à 1000 W.

4. Procédé selon l'une quelconque des revendications précédentes, **caractérisé en ce que** la pression de processus est maintenue dans la plage de 3,6 . 10⁻³ à 4,5 . 10⁻² mbar.

5. Procédé selon l'une quelconque des revendications précédentes, **caractérisé en ce que** la pression est abaissée dans la chambre (1) de plasma à basse pression avant le début de la réaction à un vide initial inférieur à la pression de processus, en particulier inférieur à 10⁻⁶ mbar.

6. Procédé selon l'une quelconque des revendications précédentes, **caractérisé en ce qu'**un support (23) de substrat est mis à la terre ou qu'une polarisation pouvant atteindre 40 W lui est appliquée.

7. Procédé selon l'une quelconque des revendications précédentes, **caractérisé en ce que** la température du substrat est inférieure à 50°C.

8. Procédé selon l'une quelconque des revendications 1 à 6, **caractérisé en ce que** la couche d'hydrocarbure polymérisée par plasma est engendrée au moyen d'un mélange contenant au moins un hydrocarbure gazeux réactif et au moins un gaz noble.

9. Procédé selon la revendication 8, **caractérisé en ce que** l'hydrocarbure gazeux introduit est l'acétylène et le gaz noble introduit est l'hélium ou l'argon.

10. Application du procédé selon l'une quelconque des revendications 1 à 9 pour fabriquer des couches fonctionnelles flexibles d'une épaisseur de 19 à 508 nm.

11. Application du procédé selon la revendication 10, pour réduire la perméabilité aux gaz, à la vapeur d'eau ou aux produits aromatiques dans des matières d'emballage, qui se composent en particulier de polypropylène, de polyéthylène, de polytéréphtalate d'éthylène ou PET, de chlorure de polyvinyle ou de polystyrène.

12. Chambre (1) de plasma à basse pression pour la mise en oeuvre du procédé selon l'une quelconque des revendications 1 à 9, **caractérisé par**
- au moins une décharge magnétron en courant continu ou à haute fréquence, mise en oeuvre de façon continue, discontinue et/ou pulsée, et/ou une source (13) de pulvérisation à magnétron en courant continu et/ou à haute fréquence à cible d'hydrocarbure, ainsi que
- au moins une décharge micro-ondes (7) mise en oeuvre de façon continue, discontinue et/ou pulsée, avec ou sans champ magnétique.

13. Chambre (1) de plasma à basse pression selon la revendication 12, **caractérisée en ce que** les dispositifs de décharge (7, 13) peuvent être réglés et mis en oeuvre indépendamment l'une de l'autre.

14. Chambre (1) de plasma à basse pression selon la revendication 12 ou 13, **caractérisée en ce qu'**un support (23) de substrat qui peut coulisser en direction des dispositifs (7, 13) est agencé de préférence dressé verticalement est prévu entre les dispositifs de décharge (7, 13).

15. Chambre (1) de plasma à basse pression selon l'une quelconque des revendications 12 à 14, **caractérisée en ce que** la source (7) de micro-ondes peut être complétée pour former une source stimulant un champ magnétique, en particulier une source à résonnance électrocyclotronique, ou source à ECR.

16. Chambre (1) de plasma à basse pression selon l'une quelconque des revendications 12 à 15, **caractérisée en ce que** des moyens générateurs d'un champ magnétique, en particulier des aimants permanents, sont prévus sur au moins un dispositif de décharge (7, 13) et/ou sur la paroi (3) de la chambre de plasma.
